# EUROPEAN PATENT APPLICATION

(11) **EP 0 921 557 A2**
(43) Date of publication of application: **09.06.1999**
(21) Application number: 98118126.6
(22) Date of filing: 24.09.1998
(51) Int. Cl.: H01L 21/00

(54) **Formation of non-homogenous device layer using an inert gas shield**

(30) Priority: 30.09.1997 US 940898
(71) Applicant: SIEMENS AKTIENGESELLSCHAFT, 80333 München (DE)
(72) Inventor: Ilg, Matthias, Richmond, VA 23220 (US); Werner, Christoph, 85665 Moosach (DE)
(74) Representative: Patentanwälte Westphal, Mussgnug & Partner

(57) **Abstract**

A method and apparatus for forming a multi-constituent device layer on a wafer surface are disclosed. The multi-constituent non-homogenous device layer is formed by flowing a first chemistry comprising a first constituent and a second chemistry comprising a second constituent via a segmented delivery system into a reaction chamber. The reaction chamber comprises a platen for supporting and rotating the wafers. The segmented delivery system comprises alternating first and second segments with third segments separating the first and second segments. The first and second chemistries are first delivered into the first and second segments, respectively, with an inert gas being delivered into the third segments.

## Description

### Field Of Invention

The invention generally relates to device fabrication and, in particular, to the formation of multi-constituent non-homogenous layers.

### Background Of Invention

In device fabrication, device structures, such as transistors, capacitors, and resistors, are formed on a substrate or wafer. These device structures are then interconnected to achieve a desired electrical function. Formation of the device structures typically comprises producing and patterning layers of insulating, semiconducting, and conducting materials on the substrate. Techniques for forming layers on a substrate include chemical vapor deposition (CVD), such as those described in Wolf et al., Silicon Processing for the VLSI Era, Vol. I, Lattice Press (1986); and Kern et al., IEEE Trans. Electron-Devices, ED-26 (1979) which are herein incorporated by reference for all purposes.

Typically, CVD techniques are performed in a reactor comprising a susceptor, heater, and chemistry delivery system. To increase the throughput of the reactor, the susceptor can be designed to support a plurality of wafers. The chemistry delivery system delivers a chemistry into the reaction chamber. The chemistry comprises one or more constituents that are to be deposited on the surface of the wafers and from which the layer is formed. In some cases, the constituents are derived from the chemistry that is flowed into the reactor, while in others they are derived in situ by, for example, reacting with other introduced chemistries. Typically, the chemistry includes a carrier agent to aid in delivering the constituents into the reaction chamber. The carrier agent, in some applications, may also serve other functional purposes; for example, O₂ acts as an oxidation agent. The heater is used to heat the reaction chamber to reaction conditions, causing the chemistry to react with the wafer surface as the chemistry is delivered therein. The reaction decomposes the chemistry, yielding the constituents that are to be deposited to form the layer. The constituents then chemically combine with the surface to form the layer. The reaction temperature and chemistry, of course, depend on the type of layer that is to be formed.

In some applications, formation of the layer comprises at least two constituents (multi-constituent). Such multi-constituent layers may be formed by delivering at least two chemistries (multi-chemistry), each comprising at least one constituent, into the reaction chamber. For example, a first chemistry comprising a first constituent and carrier agent and a second chemistry comprising a second constituent and a carrier agent are delivered into the reaction chamber and reacted to yield the constituents for forming the multi-constituent layer. A segmented delivery system is employed to deliver the different chemistries into the reaction chamber. The use of a segmented delivery system to form multi-constituent layers is desirable because it decouples process parameters, enabling easier process control.

In a conventional segmented delivery system, the reaction chamber is divided into sectors of equal size. The segmented delivery system delivers the different chemistries to alternating sectors of the reaction chamber. A susceptor or platen that supports one or more wafers is rotated. As the platen is rotated, the chemistries react and deposit the layer over the surface of the wafer.

Non-homogenous layers, such as modulated doped silicate glass (MDSG) are effectively formed using a segmented delivery system. The formation of a MDSG layer is described in the patent application titled US Patent Application No. 08/578,165 (Attorney Docket No. 95P7574), titled "Semiconductor Insulator Structure Using Modulation Doped Silicate Glass," which is herein incorporated by reference for all purposes. A MDSG layer comprises a plurality of sub-layers, wherein the sub-layers alternate in composition. For example, a first set of alternating sub-layers is formed from the first chemistry and the second set of alternating sub-layers is formed from the second chemistry.

When forming non-homogenous layers in a conventional segmented delivery system, interdiffusion of the two toward the center of the reactor occurs. This causes the composition of the resulting non-homogenous layer to vary strongly across the wafer. Such non-uniformity, although tolerable within limits, is undesirable as it affects process yields.

From the above discussion, it is apparent that there is a need for an improved technique and system for forming layers to achieve a substantially uniform distribution of the material throughout the wafer.

### Summary Of Invention

The invention relates to the formation of a multi-constituent non-homogenous device layer on a wafer surface. The device layer comprises at least first and second constituents. The layer is formed in a reaction chamber comprising a susceptor capable of supporting at least one wafer and alternating first and second segments with third segments separating the first and second segments. A wafer is placed on the susceptor and rotated. A first chemistry comprising the first constituent and a second chemistry comprising the second constituent are flowed into the first and second segments, respectively. An inert gas is flowed into the third segments.

### Brief Description Of Drawings

Fig. 1 shows a conventional CVD reactor;
Fig. 2 shows a reaction chamber of the conventional CVD reactor in detail;
Fig. 3 shows a segmented chemistry delivery system of the conventional CVD;
Fig. 4 shows a conventional segmented chemistry delivery system for forming a BPSG layer;
Figs. 5a-b show the TEOS and PH₃ concentration as a function of angular position in a conventional CVD reactor;
Fig. 6 shows a reaction chamber with a segmented delivery system in accordance with the invention;
Fig. 7 shows the TEOS and PH₃ concentration produced by simulation using a model of a segmented delivery system with an inert gas shield in accordance with one embodiment of the invention; and
Fig. 8 shows the TEOS and PH₃ concentration with respect to gas flow rate of the inert gas shield.

### Detail Description Of The Invention

The present invention relates generally to device fabrication and, particularly, to the formation of layers having a substantially uniform distribution of constituents derived from more than one chemistry. For purposes of illustration, the invention is described in the context of forming a modulated doped silicate glass (MDSG). The MDSG can include various dopants, such as phosphorus (P), boron (B), or a combination thereof. Other dopants are also useful. However, the invention is significantly broader and extends to the fabrication of non-homogenous device layers.

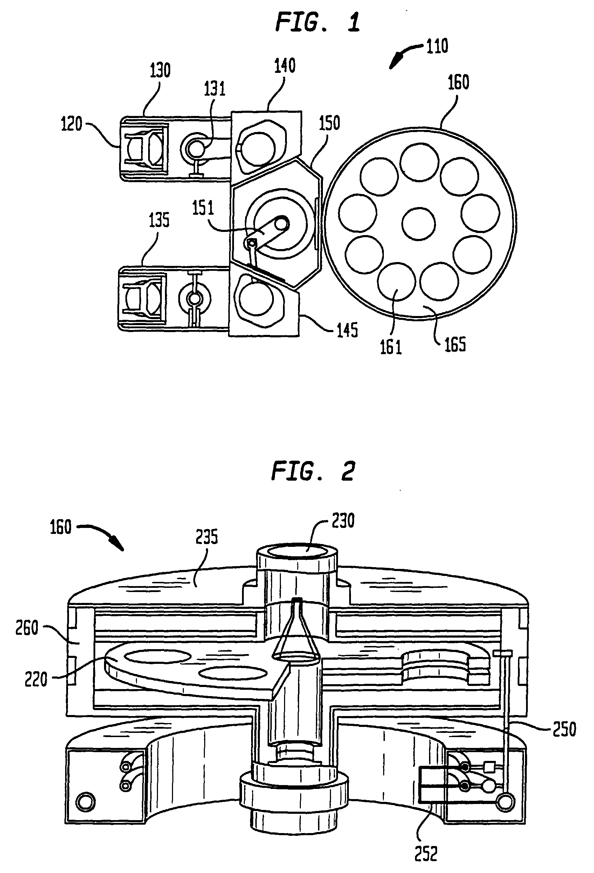

Before discussing the invention, a description of conventional CVD reactor used for forming layers is provided. Referring to Fig. 1, a simplified top view of a conventional CVD reactor 110 is shown. Such a reactor, for example, includes the Lam Integrity DSM 9800 system produced by Lam Research, Inc. in Fremont, California. As shown, reactor 110 comprises wafer cassette storage bays 130 and 135, loadlock units 140 and 145, transfer chamber 150, and reaction chamber 160. The Lam Integrity DSM 9800 is described in US Patent 4,976,996 issued to Monkowski et al., which is herein incorporated by reference for all purposes. Cassette storage bays each store a cassette, such as those used for holding and storing a plurality wafers in conventional device fabrication. The wafers in the cassettes are transferred to the respective load lock units by wafer transfer arms 131 and 132. Transfer chamber 150 includes a wafer loading arm 151. The wafer loading arm removes a wafer from either loadlock 140 or loadlock 145 and places it in a wafer slot 161 of a susceptor 165 in the reaction chamber. Illustratively, the susceptor comprises nine wafer slots. Wafers are loaded into the other slots by rotating the susceptor to the appropriate position.

Fig. 2 shows the reaction chamber 160 in greater detail. As shown, the reaction chamber comprises a susceptor 220 in a reaction area 260 of the chamber. The susceptor includes a plurality of slots for placement of a wafer therein. Typically, the slots are depressed such that the top surface of the wafer, when placed therein, is substantially planar with the surface of the susceptor. The substantially planar surface facilitates the flow of chemistry. A plurality of injectors 250 are located at the circumference of the reaction chamber. Connected to the injectors are a plurality of chemistry feed lines 250. The number of feed lines depend on the number of different types of materials used for forming the layer. The materials are mixed and delivered into the reaction area of the chamber by the injectors. Excess materials and by-products of the reaction exit the reaction chamber through an exhaust vent 230 located at the center of the chamber. As such, the direction of the flow of the chemistry is from injectors toward the center. Alternatively, reversing the direction of chemistry flow is also useful. Reversing the flow is achieved by locating the injectors at the center of the chamber and the exhaust vents at the circumference of the chamber.

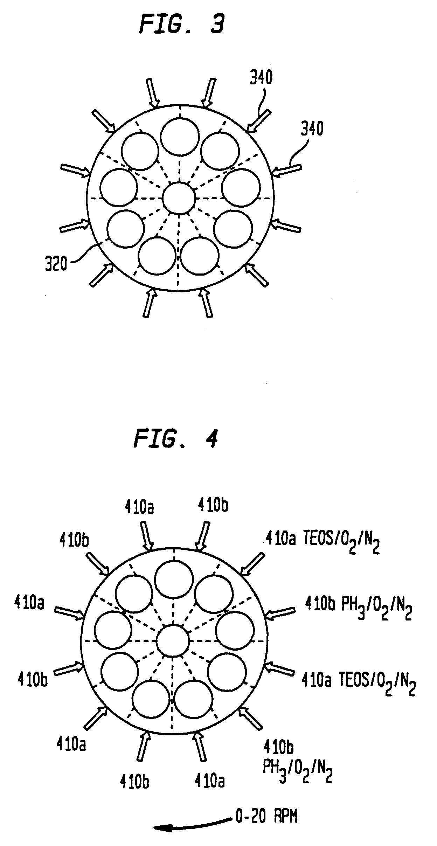

Fig. 3 shows a top view of a segmented delivery system of the conventional CVD reactor. The reaction chamber 320 is divided into a plurality of sectors having equal area. At the circumference of the reactor in each sector, a delivery injector 340 (depicted by an arrows) is provided. Illustratively, the reaction chamber comprises 12 sectors. The injectors are used to flow the appropriate chemistry into the reaction chamber. The injectors are configured such that the chemistry is flowed in a linear path from the injectors toward the center of the susceptor, i.e., center of the reaction chamber. The susceptor is rotated, enabling the chemistry to contact the surface area of the wafer.

When two chemistries are used to form a nonhomogenous layer, they are delivered into the reaction chamber via alternating injectors. For example, a nonhomogenous P doped silicate glass (PSG) layer is formed by injecting a first chemistry comprising tetraethoxysilane (TEOS) and a second chemistry comprising phosphine (PH₃). The TEOS is the source of silicon and PH₃ provides the source of phosphorus (P) dopant atoms. Typically, the chemistry includes O₂ and N₂ as oxidation and carrier gases.

Referring to Fig. 4, for example, the TEOS/O₂/N₂ chemistry is delivered by injectors 410a and the PH₃/O₂/N₂ chemistry is delivered by injectors 410b. The formation of the PSG layer is achieved using conventional process conditions, such as those described in Tedder et al., Appl. Phys. Lett. 62, p. 699 (1993), which is herein incorporated by reference for all purposes. Typical concentration of P for the non-homogenous PSG layer is about 3-10 wt%. Of course, the exact concentration depends on application and design parameters. The temperature of the reaction chamber is about 650-900°C, preferably about 750-850°C. The pressure in the reaction chamber is about 100-10,000 mTorr, preferably about 1,000-5,000 mTorr. The susceptor is rotated at less than or equal to about 20 revolutions per minutes (rpm), preferably less than or equal to about 5 rpm.

Fig. 5a shows an exemplary section 650 of a reaction chamber having twelve sectors of about 30° each. As shown, section 650 is about 60° and comprises injectors 660a-b and 665. Injectors 660a-b deliver TEOS/O₂/N₂ chemistry into the chamber; injector 665 delivers PH₃/O₂/N₂ into the chamber. As such, areas 670 of the section represent TEOS/O₂/N₂ sectors and area 675 is the PH₃/O₂/N₂ sector. A theoretical gas flow simulation of the two chemistries was conducted on a Phoenics CVD 2.1 simulator provided by Cham which is located in London, England. The simulation emulated the following process conditions:
- Pressure in the reaction chamber :: 1 Torr
- PH₃/O₂/N₂ injectors :: 6.25 slm N₂
1.2 slm PH₃
- TEOS/O₂/N₂ injectors :: 2.5 slm N₂
8.0 ml/min TEOS
- Temperature in the reaction chamber :: 830°C
- Susceptor rotation :: 3.5 rpm

slm: standard liters per minute (gas)
ml/mm: milliliters per minute (liquid injection)

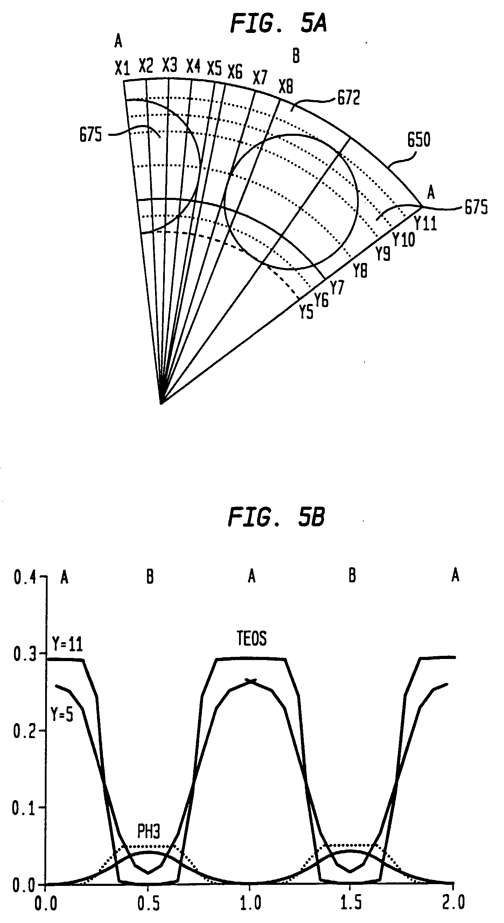

Fig. 5b is a plot of the concentration of gases that are injected into the chamber. The concentration of TEOS and PH3 gases are measured with respect to the angular positions (in radians) in section 650 and radial position (see Fig. 5a). Line 670 measures the concentration of TEOS gases at radial position y11, which is at the wafer edge closest to the injectors with respect to the angular position. Line 671 measures the concentration of TEOS gases at radial position y5, which is at the wafer edge closest to the center of the chamber with respect to the angular position. Line 680 measures the concentration of PH₃ gases at radial position y5, which is at the wafer edge closest to the center of the chamber with respect to the angular position. Line 681 measures the concentration of PH₃ gases at radial position y11, which is at the wafer edge closest to the injectors with respect to the angular position.

As evidenced by Fig. 5b, TEOS and PH₃ gases tend to diffuse into respective neighboring sectors. Close to the injectors, a sharp distribution and clear separation of the gases are exhibited. Moving toward the center, the profiles are not distinctly separated due to the fact that the two chemistries are being commingled or intermixed together. Intermixing of the chemistries causes the modulation of the layers to loose amplitude across the wafer. This results in non-uniform properties of the material across the wafer.

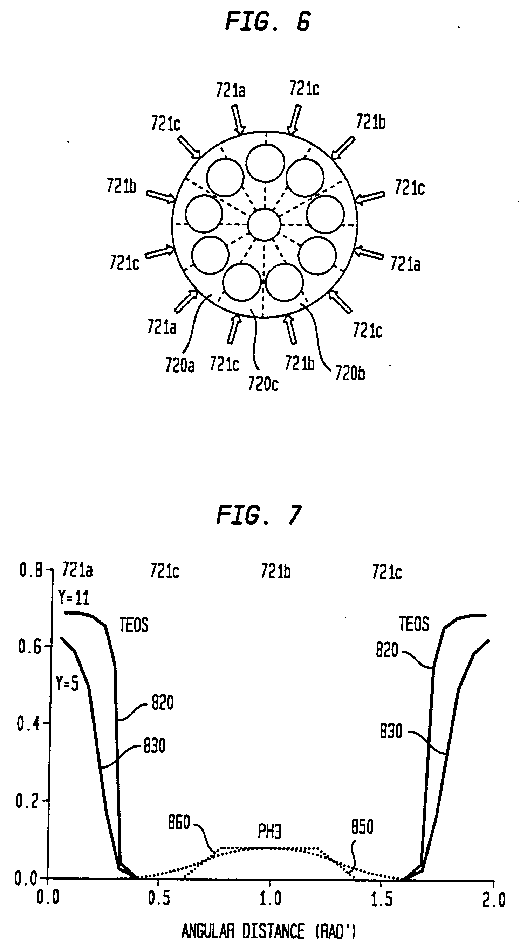

In accordance with the invention, a non-homogenous layer formed from two chemistries with improved uniformity across the wafer is provided. The improved uniformity is achieved by providing an inert gas shield between the first and second chemistries. The inert gas shield reduces or minimizes intermixing of the chemistries. Referring to Fig. 6, a simplified diagram of a reaction chamber from a CVD reactor in accordance with one embodiment of the invention is shown. Illustratively, the reaction chamber comprises a circular type susceptor 810 for supporting a plurality of wafers in a circular configuration (not shown).

The reaction chamber is divided into a plurality of sectors 720a, 720b, and 720c. The exemplary reaction chamber is divided into 12 sectors. Sectors 720a, 720b, and 720c comprise injectors 721a, 721b, and 721c, respectively. Injectors 821a flow a first chemistry and injectors 821b flow a second chemistry. Injectors 721c, which are located in between injectors 721a and 721b, flow an inert gas, such as nitrogen (N₂). Other inert gases, such as He or Ar, are also useful. The N₂ serves as an inert gas shield to separate two chemistries. The inert gas shield reduces or minimizes reactants from the different chemistries from diffusing into different sectors. This results in more uniform layer properties. In one embodiment, TEOS/O₂/N₂ chemistry is flowed through injectors 721a, PH₃/O₂/N₂ chemistry is flowed through injectors 721b, and N₂ is flowed through injectors 721c to form a P-MDSG layer.

Alternatively, other chemistries are used to form doped non-homogenous layers. For example, TEB/O₂/N₂ and TEOS/O₂/N₂ chemistries are used to form B doped nonhomogenous layer, or PH₃/O₂/N₂ and TEB/TEOS/O₂/N₂ chemistries are used to form B and P doped non-homogenous layers.

A theoretical gas flow simulation of TEOS/O₂/N₂ and PH₃/O₂/N₂ chemistries being injected into a chamber with a N2 shield was conducted on a Phoenics CVD 2.1 simulator. The chamber was divided into twelve 30° sectors. The simulation emulated the following process conditions:
- Pressure in the reaction chamber :: 1 Torr
- PH₃/O₂/N₂ injectors :: 6.25 slm N₂
1.2 slm PH₃
- TEOS/O₂/N₂ injectors :: 2.5 slm N₂
7.15 ml/min TEOS
- N₂ :: 5 slm
- Temperature in the reaction chamber :: 830°C
- Susceptor rotation :: 3.5 rpm

slm: standard liters per minute (gas)
ml/mm: milliliters per minute (liquid injection)

Referring to Fig. 7, the results of the simulation are plotted. The plot shows a 120° section of the reaction chamber. Line 820 measures the concentration of the TEOS gas at radial position y11, which is at the wafer edge closest to the injectors with respect to the angular position. Line 830 measures the concentration of the TEOS gas at radial position y5, which is at the wafer edge closest to the center of the chamber with respect to the angular position. Line 840 measures the concentration of PH₃ gas at radial position y5, which is at the wafer edge closest to the injectors with respect to the angular position. Line 850 measures the concentration of PH3 gas at radial position y11, which is at the wafer edge closest to the injectors with respect to the angular position.

As evidenced by Fig. 7, the inert gas shield separates the TEOS and PH₃ concentration curves across the wafer. This leads to a non-homogenous layer with more pronounced modulations and uniformity across the wafer.

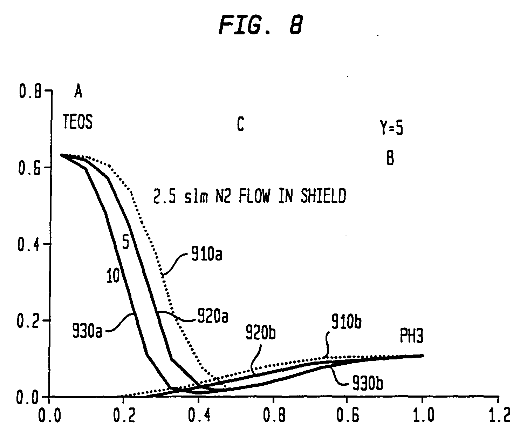

It has been found that the flow rate of the inert gas shield affects the separation of the first and second chemistries. Fig. 8 is a simulation showing the effects of flow rate of N₂. Lines 910a-b represent the concentration of TEOS and PH₃ gases with respect to radial position with N₂ flow rate of 2.5 slm. Lines 920a-b represent the concentration of TEOS and PH₃ gases with respect to radial position with an N₂ flow rate of 5 slm. Lines 930a-b represent the concentration of TEOS and PH₃ gases with respect to radial position with N₂ flow rate of 10 slm. As can be seen, the higher the N2 flow rate, the more distinct the separation between the TEOS and PH₃. Typically, the flow rate of the inert gas is in the range of about 2-10 slm, preferably about 5-10 slm. Of course, the flow rate can vary depending on application and design parameters.

While the invention has been particularly shown and described with reference to various embodiments, it will be recognized by those skilled in the art that modifications and changes may be made to the present invention without departing from its scope. The scope of the invention should therefore be determined not with reference to the above description but with reference to the appended claims along with their full scope of equivalents.

## Claims

1. In device fabrication, a method for forming a multi-constituent non-homogenous device layer on a wafer surface, the device layer comprising first and second constituents is being formed in a reaction chamber comprising a platen capable of supporting at least one wafer and alternating first and second segments with third segments separating the first and second segments, the method comprising:
providing at least one wafer on the susceptor;
rotating the susceptor;
delivering a first chemistry comprising the first constituent into the first segments of the reaction chamber;
delivering a second chemistry comprising the second constituent into the second segments of the reaction chamber; and
delivering an inert gas into the third segments of the reaction chamber.
